(11) **EP 1 974 850 B1**

(12) **EUROPEAN PATENT SPECIFICATION**

(45) Date of publication and mention
of the grant of the patent:
**06.04.2016 Bulletin 2016/14**

(21) Application number: **07706755.1**

(22) Date of filing: **15.01.2007**

(51) Int Cl.:
**B23K 35/26** *(2006.01)*     **C22C 13/00** *(2006.01)*
**B23K 35/30** *(2006.01)*     **B23K 35/02** *(2006.01)*
**H01L 23/00** *(2006.01)*     **H05K 3/24** *(2006.01)*

(86) International application number:
**PCT/JP2007/050421**

(87) International publication number:
**WO 2007/081006 (19.07.2007 Gazette 2007/29)**

(54) **SOLDER ALLOY, SOLDER BALL AND SOLDER JOINT USING SAME**

LÖTLEGIERUNG, LÖTKUGEL UND DIESE VERWENDENDE LÖTVERBINDUNG

ALLIAGE DE SOUDURE, BILLE DE SOUDURE ET JOINT DE SOUDURE L'UTILISANT

(84) Designated Contracting States:
**DE FI FR NL**

(30) Priority: **16.01.2006 JP 2006007425**
           **04.10.2006 JP 2006272589**

(43) Date of publication of application:
**01.10.2008 Bulletin 2008/40**

(73) Proprietor: **HITACHI METALS, LTD.**
**Minato-ku,**
**Tokyo 105-8614 (JP)**

(72) Inventors:
• **FUJIYOSHI, Masaru**
 **Yasugi-shi, Shimane 682-0011 (JP)**

• **DATE, Masayoshi**
 **Yasugi-shi, Shimane 692-0011 (JP)**

(74) Representative: **Strehl Schübel-Hopf & Partner**
**Maximilianstrasse 54**
**80538 München (DE)**

(56) References cited:
**CN-A- 1 803 381**      **JP-A- 11 077 366**
**JP-A- 11 277 290**      **JP-A- 2000 190 090**
**JP-A- 2001 096 394**      **JP-A- 2002 057 177**
**JP-A- 2002 239 780**      **JP-A- 2003 230 980**
**JP-A- 2003 230 980**      **JP-A- 2003 268 403**

**Description**

TECHNICAL FIELD

The present invention relates to a solder alloy used in soldering of electronic parts, etc., a solder ball, and a solder joint.

BACKGROUND ART

In recent years, as mobile devices such as cellular phone, etc. are decreased in mount area, there is a tendency of miniaturization in semiconductor packages. A mount configuration in which a semiconductor package is connected to a mother board has undergone changes to a type in which electrodes are formed in a grid, from a peripheral type in which conventional lead-frame is used. BGA (Ball Grid Array) is a typical one and its electrodes are connected to a mother board by means of spherically formed solder, that is, solder balls.

Different external forces are sometimes applied to a semiconductor package, and a drop impact can be listed as an external force peculiar to mobile devices. This is because a mobile device may carelessly be dropped when it is used or carried. With conventional peripheral type packages, lead-frame is deformed, thereby enabling cushioning such external force. On the other hand, since BGA is joined directly to a mother board by means of solder balls without lead-frame, it is required that solder joints absorb an external force in order to prevent a semiconductor package and a mother board from being broken. Consequently, reliability in solder joints when a drop impact is applied is very important in extending the service life of a mobile device.

Meanwhile, a Pb-free solder material is recommended all over the world as one of activities to address environmental problems in recent years, typified by RoHS (the restriction of the use of certain hazardous substances) Directive of EU, and the use of Sn-Pb eutectic solder, which has been conventionally used, is being inhabited. Sn alloys, such as Sn-3Ag-0.5Cu (by mass%), Sn-3.5Ag-0.75Cu (by mass%), etc., can be listed as main alternate solders.

While Sn has a melting temperature of 232°C, the melting temperature can be lowered to around 220°C by addition of Ag and Cu whereby a soldering temperature is made low to enable suppressing thermal damage to semiconductor packages. However, since Ag and Cu in Sn form an intermetallic compound with Sn to harden solder, the ductility is poor compared to that of conventional Sn-Pb eutectic solder. Consequently, there is caused a serious problem that fracture is liable to occur along a solder joint interface when a mobile device is dropped. Thus, there is a rapidly increasing demand for a Pb-free solder material having excellent drop impact resistance.

The following two approaches are conceived as a method for improving the impact resistance of a solder joint. One of them is to improve the ductility of solder to be well deformed, which is achieved by reducing the contents of Ag and Cu in solder. With regard to the amount of additive alloying elements, a eutectic composition having a lowest melting temperature can be obtained when 3.5 mass% Ag and 0.75 mass% Cu are added in Sn. However, it is necessary to add a larger amount of Ag than Cu in order to lower the melting temperature of the solder whereby arising a problem that the solder becomes harder. In this relation, according to Patent Publication 1 and Patent Publication 2, mechanical properties of solder are improved with use of a Sn-Cu alloy containing a small amount of Ag, or without Ag.

The other approach is to improve the strength of a solder joint interface. For example, Patent Publication 1 teaches that when a Sn-Cu alloy containing not less than 0.7 mass% Cu is provided on Ni, a Cu-Ni-Sn compound formed at a solder joint interface does not exfoliate from Ni, whereby a stable joint is obtained. Patent Publication 1 further teaches that when a solder containing a much amount of Cu is provided on a Cu electrode, it is possible to inhibit erosion of the Cu electrode whereby attaining improved solder joint strength.

In order to improve solder joint strength, Patent Publication 3 has proposed a Sn-Ag-Cu-Ni based solder alloy containing 0.5 to 5.0 mass% Ag, 0.3 to 1.5 mass% Cu, 0.05 to 1.0 mass Ni, and the balance of Sn mass% Cu, 0.05 to 1.0 mass% Ni, and the balance of Sn and unavoidable impurities, which solder alloy forms an irregular layer of an interface compound when provided on an Ni electrode, the irregular layer exhibiting an anchor effect thereby inhibiting an occurrence probability of fracture at the interface to improve the solder joint strength. In Patent Publication 3, such effect has been specifically confirmed with use of a solder alloy containing 1.0 mass% Ag, 0.5 mass% Cu and 0.1 mass% Ni, and the balance being Sn and unavoidable imparities.

Patent Publication 1: JP-A-11-221695
Patent Publication 2: JP-A-2000-190090
Patent Publication 3: .JP-A-2003-230980

PROBLEMS TO BE SOLVED BY THE INVENTION

In this manner, Sn-Cu alloys have advantage of having a lower melting temperature than Sn whereby restraining thermal damage to semiconductor packages when soldering, and of a stable joint strength when provided on a Ni electrode or a Cu electrode.

However, for the Sn-Cu-based alloys disclosed in Patent Publications 1 and 2, it has turned out that when a Sn-Cu alloy with a high content of Cu is provided on an Ni electrode and exposed to a high temperature for a long time due to, for example, heat generated in the semiconductor package, a Cu-Ni-Sn compound grows to be thick resulting in adversely affecting the adhesion strength of the alloy.

According to a particular solder alloy, corresponding to a Sn-Cu alloy with additive Ag in a small amount which does not deteriorate the soldier alloy in a property of resistance to an impact, it is possible to restrain growth of the Cu-Ni-Sn compound under a high temperature environment while a stable joint strength of the solder alloy is not attained.

Further, when solder alloys disclosed in Patent Publication 3 are soldered to Ni electrodes, the solder alloys being Sn-1.0Ag-0.5Cu-0.1Ni, Sn-1.5Ag-0.5Cu-0.1Ni, Sn-2.5Ag-0.5Cu-0.1Ni, Sn-3.0Ag-0.5Cu-0.1Ni, Sn-4.0Ag-0.5Cu-0.1Ni and Sn-2.5Ag-1.0Cu-0.1Ni (by mass%), the solder joints, which have been exposed to a high temperature environment for a short time of around 100 hours, can maintain their joint strength because no growth of the Cu-Ni-Sn compound occurs. However, if the solder joints are exposed to the high temperature environment for a longer time of not less than 500 hours, there occur a significant growth of the Cu-Ni-Sn compound whereby the joint strength is deteriorated because such a grown compound cannot exhibit the anchor effect.

An object of the present invention is to provide a Pb-free solder alloy, which has an excellent property of resistance to drop impact, and of which joint strength is restrained in deterioration even after long time exposure to a high temperature environment, a solder ball, and a solder joint.

MEANS FOR SOLVING THE PROBLEMS

The present inventors found that it is possible to maintain sufficient joint strength of a Sn-Cu alloy even after long time exposure to a high temperature environment by adding a strictly controlled amount of Ag and Ni into the Sn-Cu alloy, whereby the present invention has been achieved.

Thus, according to the present invention, there is provided a solder alloy consisting essentially of, by mass, 0.1 to 1.5% Ag, 0.5 to 0.75% Cu, Ni in an amount defined by the equation of $12.5 \leq Cu/Ni \leq 100$, and the balance of Sn and unavoidable impurities.

Preferably, the solder alloy contains 0.3 to 1.2 mass% Ag.

Preferably, the solder alloy contains 0.01 to 0.04 mass% Ni.

The solder alloy of the invention can be used as a spheroidized solder ball.

Preferably the invention solder alloy is provided on a Ni electrode so as to form a solder joint.

According to the invention, it is possible to maintain the joint strength by preventing, as far as possible, occurrence of compounds other than a single compound of $(Cu, Ni)_6Sn_5$ under a high temperature environment, so that a high connection reliability can be maintained even under an elevated temperature during use of a mobile device.

BRIEF DESCRIPTION OF THE DRAWINGS

Fig. 1 is a scanning electron micrograph of a solder joint section of Invention Example 1 after exposure to 150°C for 500 hours;

Fig. 2 is a scanning electron micrograph of a solder joint section of Invention Example 3 after exposure to 150°C for 500 hours;

Fig. 3 is a scanning electron micrograph of a solder joint section of Invention Example 4 after exposure to 150°C for 500 hours;

Fig. 4 is a scanning electron micrograph of a solder joint section of Invention Example 5 after exposure to 150°C for 500 hours;

Fig. 5 is a scanning electron micrograph of a solder joint section of Comparative Example 2 after exposure to 150°C for 500 hours;

Fig. 6A is a scanning electron micrograph of a solder joint section of Invention Example 1 exposure to 150°C for 500 hours;

Fig. 6B shows a line analysis result corresponding to the scanning electron micrograph shown in Fig. 6A;

Fig. 7A is a scanning electron micrograph of a solder joint section of Invention Example 3 after exposure to 150°C for 500 hours;

Fig. 7B is a line analysis result for the scanning electron micrograph shown in Fig. 7A;

Fig. 8A is a scanning electron micrograph of a solder joint section of Invention Example 4 of the present invention after exposure to 150°C for 500 hours;

Fig. 8B is a line analysis result for the scanning electron micrograph shown in Fig. 8A;

Fig. 9A is s a scanning electron micrograph of a solder joint section of Invention Example 5 of the present invention after exposure to 150°C for 500 hours;

Fig. 9B is a line analysis result for the scanning electron micrograph shown in Fig. 9A;

Fig. 10A is a scanning electron micrograph of a solder joint section of Comparative Example 2 after exposure to 150°C for 500 hours;

Fig. 10B is a line analysis result for the scanning electron micrograph shown in Fig. 10A;

Fig. 11 is a scanning electron micrograph of a solder joint section of Invention Example 6 of the present invention after exposure to 150°C for 500 hours;

Fig. 12 is a scanning electron micrograph of a solder joint section of Invention Example 7 of the present invention after exposure to 150°C for 500 hours;

Fig. 13A is a scanning electron micrograph of a solder joint section of Invention Example 6 of the present invention after exposure to 150°C for 500 hours;

Fig. 13B is a line analysis result for the scanning electron micrograph shown in Fig. 13A;

Fig. 14A is a scanning electron micrograph of a solder joint section of Invention Example 7 of the present invention after exposure to 150°C for 500 hours; and

Fig. 14B is a line analysis result for the scanning electron micrograph shown in Fig. 14A.

EXAMPLE

As stated above, a key aspect of the invention solder alloy resides in that a sufficient solder joint strength can be maintained by optimizing the additive amounts of Ag and Ni in the Sn-Cu alloy so as not to deteriorate the alloy property of resistance to impact whereby restraining the growth of compounds of (Cu, Ni) and Sn formed at a solder_joint interface even in the case where the solder alloy is applied to a Ni electrode as well as a Cu electrode, and forming only the $(Cu, Ni)_6Sn_5$ compound, as far as possible, at the solder joint interface.

According to present inventor's consideration, in the case of a Sn-Cu-Ag-Ni solder alloy, if an additive amount of Ni therein is excessive, there is a possibility that two layers of

$(Cu, Ni)_6Sn_5$ and $(Ni, Cu)_3Sn_4$ compounds at the solder joint interface under a high temperature environment. With regard to the above solder joint with the two compound layers, it was confirmed that there occurred an exfoliation at the interface between the layers of $(Cu, Ni)_6Sn_5$ and $(Ni, Cu)_3Sn_4$ whereby the solder joint strength was adversely deteriorated. Thus, the amounts of additive elements are strictly controlled in the present invention. Hereinbelow there will be provided reasons why the amounts of the additive elements are limited.

Cu: 0.5 to 0.75 mass%

Although the melting temperature of the solder alloy is lowered by addition of Cu, such an effect is small when the Cu content is less than 0.5 mass%. In the case of a Cu electrode, for example, up to about 0.8 mass% Cu in the Cu electrode dissolves into Sn during soldering, but if the Cu content is not less than 0.5 mass%, it is sufficient in order to restrain deterioration of the solder joint strength since the Cu electrode is less dissolved in such a solder joint.

Further, the addition of Cu in an amount of more than 0.75 mass% makes a melting temperature of the solder alloy to rise whereby the soldering temperature is required to increase resulting in a thermal damage in the semiconductor package.

For example, when the Cu amount exceeds 0.75 mass%, Cu becomes surplus whereby a coarse Cu-Ni-Sn compound is formed not only at the solder joint interface but also inside the solder resulting in deterioration of the solder in ductility.

The Ni content should satisfy the following equation with relation to the Cu content:

$$12.5 \leq Cu/Ni \leq 100$$

If the Cu content is smaller than 12.5Ni, it becomes difficult that the $(Cu, Ni)_6Sn_5$ compound solely exists under high temperature conditions, and the $(Ni, Cu)_3Sn_4$ compound will bes also precipitated. Accordingly, when a solder-joint strength test is conducted, an exfoliation occurs at the interface between the compounds of $(Cu, Ni)_6Sn_5$ and $(Ni, Cu)_3Sn_4$ whereby the solder-joint strength is deteriorated. On the other hand, if the Cu content exceeds 100Ni, since the amount rate of Ni in the Cu-Ni-Sn compound is small, the growth of the Cu=Ni-Sn compound can not be restrained, so that it is difficult to maintain the solder-joint strength.

Further, since the strictly-controlled Ni content in the solder alloy of the present invention forms a compound together with Sn, Ni is included in the Cu-Ni-Sn compound to prevent formation of Cu-Ni-Sn compounds other than the $(Cu, Ni)_6Sn_5$ compound, thereby making it possible to restrain deterioration of strength.

Preferably Ni is added in an amount of 0.01 to 0.04 mass%.

Ag: 0.1 to 1.5 mass%

While it is possible to lower a melting temperature of the alloy, and broaden the zone of coexistent solid and liquid phases of the alloy by additive Ag, if the additive amount of Ag is less than 0.1 mass%, such effects are hardly expectable. Although those effects are obtainable when the Ag content is not less than 0.1 mass%, if the Ag content exceeds 1.5 mass%, Ag forms an intermetallic compound with Sn in the solder alloy whereby causing it to be harder to deteriorate its drop impact resistance property, and causing it to have a chemical composition close to a Sn-Ag-Cu ternary eutectic composition so that the zone of coexistent solid and liquid phases of the alloy is reduced.

A preferable Ag content is 0.3 to 1.2 mass% according to which it is possible to broaden the zone of coexistent solid and liquid phases of the solder alloy without deterioration thereof in ductility whereby effectively improving a surface texture of the alloy. Further, when the alloy is bonded to an Ni electrode, for example, a pinning effect which restrains growth of a Cu-Ni-Sn compound on the Ni electrode is effectively exhibited whereby restraining deterioration of bonding strength under a high temperature.

Furthermore, since Ag forms an intermetallic compound with Sn, more specifically, $Ag_3Sn$, which exists in solder in a dispersed manner, when the Cu-Ni-Sn compound grows, Ag exhibits a pinning effect so as to delay the growth of the compound.

The invention solder alloy can be bonded to various types of alloy electrodes. This is because when it is bonded to various types of alloy electrodes, even if the Cu-Ni-Sn compound is exposed to a high temperature, Ag forms a compound with Sn to exhibit a pinning effect whereby enabling reduction of deterioration of bonding strength under such a high temperature.

In the case where the solder alloy is bonded to a Cu electrode, it is possible to maintain the bonding strength because the Cu electrode is eroded only little by virtue of not less than 0.5 mass% Cu contained in the solder alloy.

In the case where the solder alloy is bonded to a Ni electrode, the same effect as the above is obtainable, while a metal layer such as Au or Pd may be provided on the Ni electrode in some cases in order to restrain oxidization of Ni whereby improving wettability of solder.

Example

Ag and Ni were added into Sn-Cu alloys to obtain some specimen solder alloys, whereafter solder balls each having a diameter of 0.3 mm were prepared. There are shown chemical compositions of specimen solder alloys in Table 1. The solder balls were prepared by a uniform droplet spray method. In the uniform droplet spray method, each of the solder alloys was melted in a crucible whereafter molten solder was discharged from the crucible to form fine balls. Vibration was applied to the molten solder during discharging from the crucible in order to form the discharged molten metal to be fine balls having a uniform volume. It is noted that in the forming method, the cooling rate when discharging was about 100°C/second. A-Sn-Ag-Cu-based solder of Comparative Specimen 1 was prepared in order to compare specimens with and without additive Ni with one another. A solder alloy disclosed in JP-A-2003-230980 was prepared as Comparative Example 2.

Table 1

|  | Chemical composition (mass%) | | | | Cu/Ni |
|---|---|---|---|---|---|
|  | Ag | Cu | Ni | Sn |  |
| Comparative Specimen 1 | 0.3 | 0.7 | - | Bal. | - |
| Comparative Specimen 2 | 1.2 | 0.5 | -0.05 | Bal. | 10 |
| Invention Specimen 1 | 1.2 | 0.5 | 0.025 | Bal. | 20 |
| Invention Specimen 2 | 1.2 | 0.5 | 0.04 | Bal. | 12.5 |
| Invention Specimen 3 | 0.3 | 0.7 | 0.05 | Bal. | 14 |
| Invention Specimen 4 | 1.2 | 0.7 | 0.035 | Bal. | 20 |
| Invention specimen 5 | 1.2 | 0.7 | 0.05 | Bal. | 14 |
| Invention Specimen 6 | 1.08 | 0.7 | 0.02 | Bal. | 35 |

(continued)

| | Chemical composition (mass%) | | | | Cu/Ni |
| --- | --- | --- | --- | --- | --- |
| | Ag | Cu | Ni | Sn | |
| Invention Specimen 7 | 1.04 | 0.7 | 0.01 | Bal. | 70 |

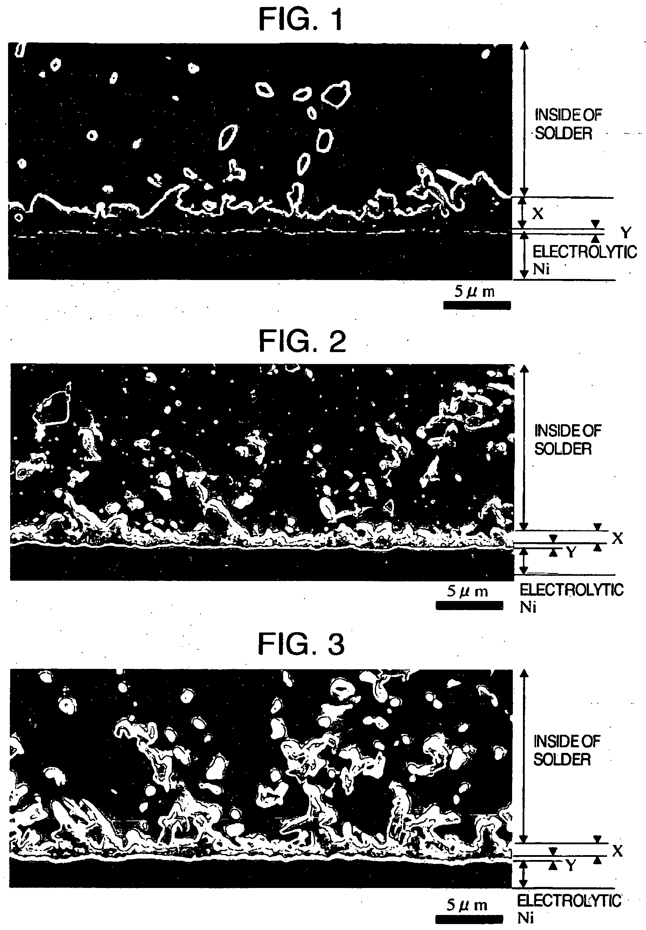

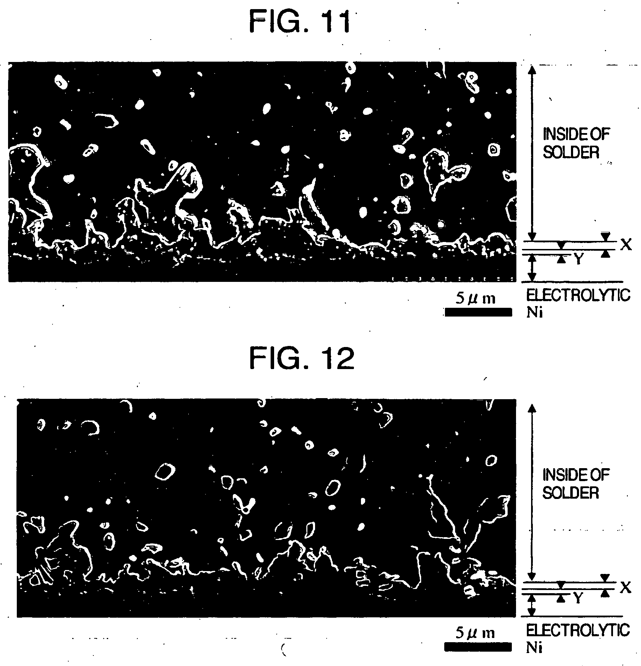

Solder bumps were formed on electrodes each provided with electrolytic Ni/Au plating (hereinafter, the electrodes will be referred to as the "Ni electrodes") with use of solder balls each having a diameter of 0.3 mm, chemical compositions of which are shown in Table 1, in order to evaluate reliability of solder joints. The Ni electrodes had a diameter of 0.25 mm. Soldering was carried out by heating the specimens up to 240°C. In order to evaluate deterioration behaviors under a high temperature, heat-treated specimens were also prepared by keeping those at a temperature of 150°C for 500 hours after soldering. The thus prepared specimens were subjected to an inspection of cross sectional metal structure, respectively, in order to determine the thicknesses of the compounds. The inspection of cross-sectional metal structure was carried out with utilization of a scanning electronic microscope (S-3500N produced by HITACHI Ltd.). The thickness of each Cu-Ni-Sn compound was determined by calculation of an area of the compound at an interface of bonding observed in a photograph of a cross-sectional microstructure, and further calculation of a thickness of the compound per unit length of the interface of bonding. A test result of these is shown in table 2. Cross-sectional metal structures of Invention Specimens 1 and 3-7, and Comparative Specimen 2 are shown in Fig. 1 to 5, 11 and 12, respectively.

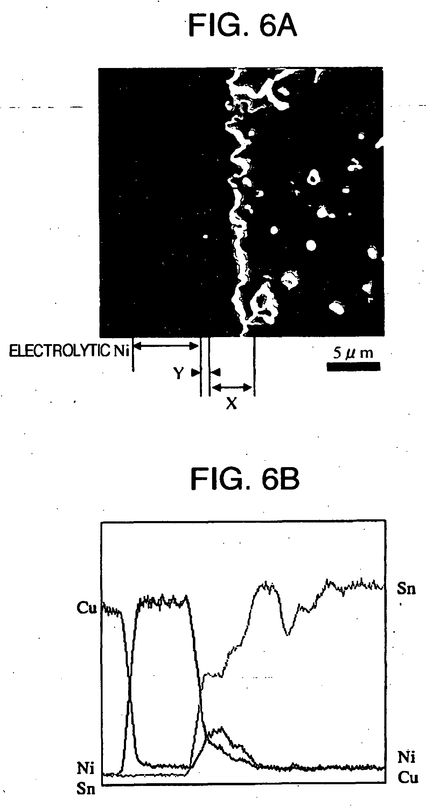

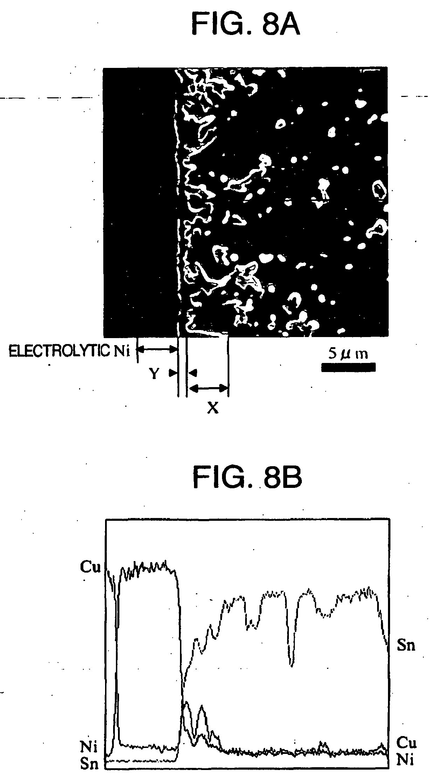

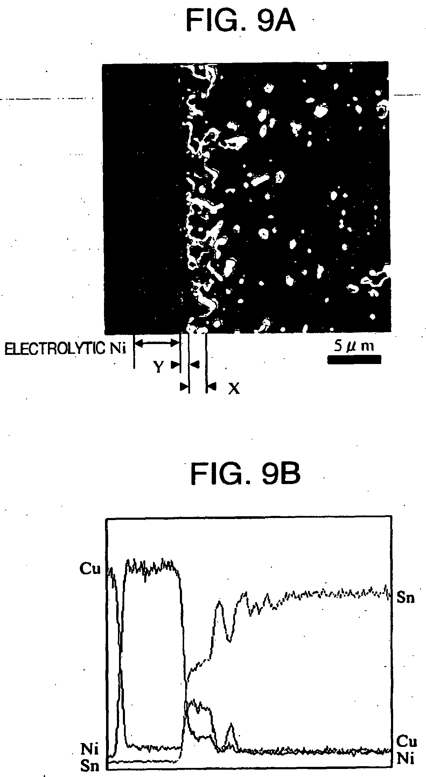

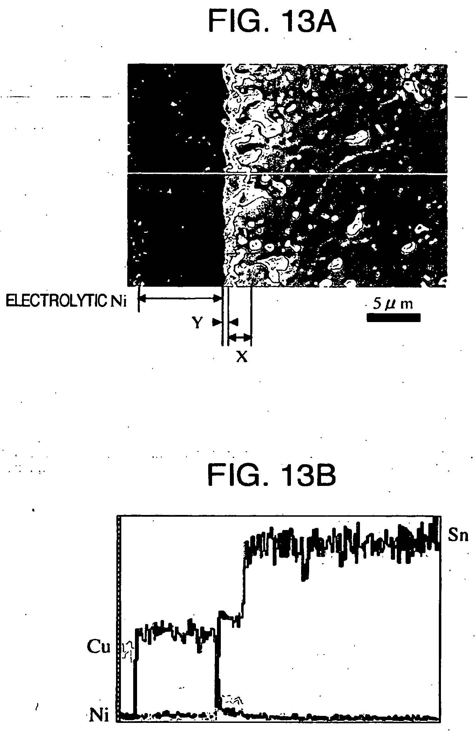

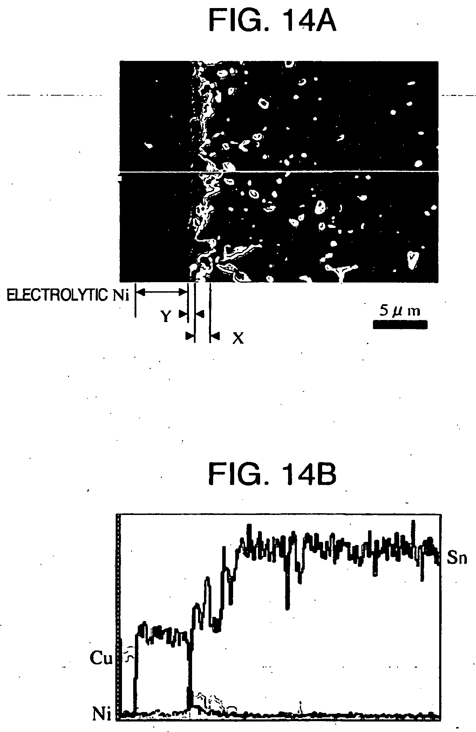

Next, the compositions of the compounds were investigated by means of line analysis. Line analysis was performed with utilization of a characteristic X-ray element analyzer (EMAX-7000 manufactured by Horiba, Ltd.). Figs. 6A, 6B, 7A, 7B, 8A, 8B, 9A, 9B, 10A, 10B, 13A, 13B, 14A and 14B show the line analysis results of Invention Specimens 1, 3, 4 and 5 and Comparative Specimen 2 as representative examples.

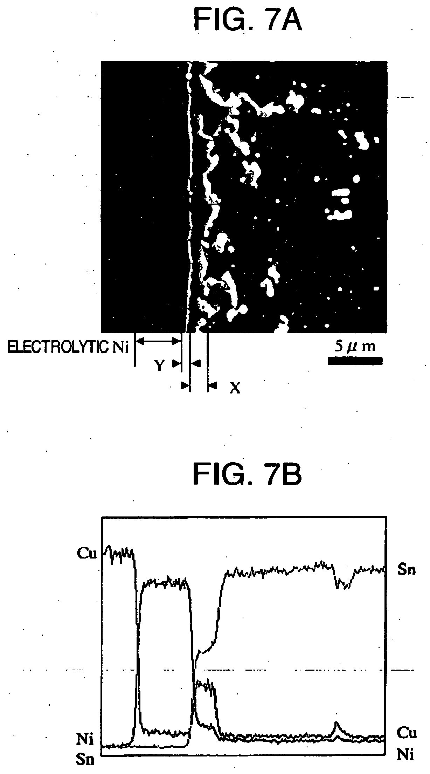

In Invention Specimens 1 and 3, as shown in Figs. 6A, 6B, 7A and 7B, there exist no areas of high Sn concentration directly above the Ni electrode. Thus, taking account of the result of observation of the concentration ratio of the Cu-Ni-Sn compound at the fracture face after the test, the interface compound can be presumed to be $(Cu, Ni)_6Sn_5$.

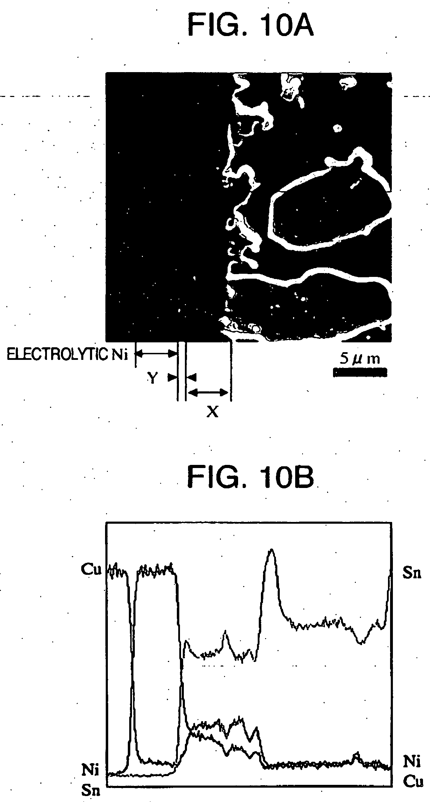

In Comparative Specimen 2, as shown in Figs. 10A and 10B, there exist areas of high Sn concentration directly above the Ni electrode. Also observing the concentration ratio of the Cu-Ni-Sn compound at the fracture face in Comparative Specimen 2, the interface compound exhibits a two-layer structure of $(Cu, Ni)_6Sn_5$ and $(Ni, Cu)_3Sn_4$, and the thickness of the $(Ni, Cu)_3Sn_4$ compound can be presumed to 1.2 $\mu$m.

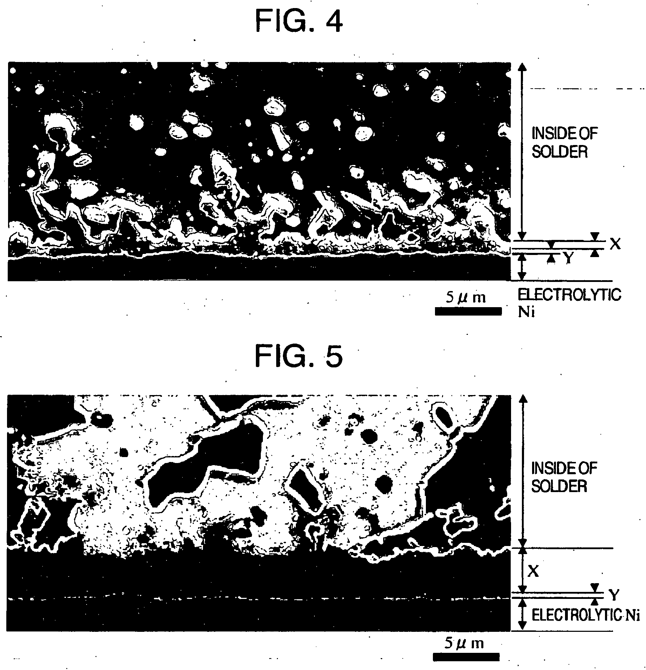

As can be seen from Table 2 and Figs. 1, 2, 6 and 7, in Invention Specimens 1 and 3, the growth of the compound was restrained by Ag and Ni, and the $(Cu, Ni)_6Sn_5$ compound is formed. On the other hand, as can be seen from Table 2 and Figs. 5 and 10, in Comparative Specimen 2, the $(Cu, Ni)_6Sn_5$ and $(Ni, Cu)_3Sn_4$ compounds were formed and the compound thickness is larger as compared with those of Invention Specimens 1 and 3.

Table 2

| | Thickness of compound ($\mu$m) | | Growth thickness ($\mu$m) | Chemical composition of compound at an interface after heating at 150°C for 500h |
| --- | --- | --- | --- | --- |
| | after soldering | after heating at 150°C for 500h | | |
| Comparative Specimen 1 | 1.7 | 3.5 | 1.8 | $(Cu,Ni)_6Sn_5$ |
| Comparative Specimen 2 | 1.5 | 4.8 | 3.3 | $(Cu,Ni)_6Sn_5$, $(Ni,Cu)_3Sn_4$ |
| Invention Specimen 1 | 1.5 | 3.0 | 1.5 | $(Cu,Ni)_6Sn_5$ |
| Invention Specimen 2 | 1.6 | 3.2 | 1.6 | $(Cu,Ni)_6Sn_5$ |
| Invention Specimen 3 | 1.6 | 2.9 | 1.3 | $(Cu,Ni)_6Sn_5$ |
| Invention Specimen 4 | 1.4 | 3.0 | 1.6 | $(Cu,Ni)_6Sn_5$ |

(continued)

| | Thickness of compound (μm) | | Growth thickness (μm) | Chemical composition of compound at an interface after heating at 150°C for 500h |
| --- | --- | --- | --- | --- |
| | after soldering | after heating at 150°C for 500h | | |
| Invention Specimen 5 | 1.6 | 3.1 | 1.5 | $(Cu,Ni)_6Sn_5$ |
| Invention Specimen 6 | 1.7 | 3.4 | 1.7 | $(Cu,Ni)_6Sn_5$ |
| Invention Specimen 7 | 1.6 | 3.6 | 2.0 | $(Cu,Ni)_6Sn_5$ |

As one method of evaluating reliability of solder joints, a micro shot test, in which a pendulum having a weight of 20g was made to strike against a solder bump at a speed of 1 m/second, was conducted with utilization of a small Charpy impact tester in order to determine the probability of occurrence of a fracture at an interface of the solder joint. Such measurement was conducted for 25 solder bumps.

Further, as another method of evaluating reliability of solder joints, a pull test, in which a solder bump was gripped and subsequently pulled at a speed of 300 μm/second, was conducted with utilization of a pull tester in order to determine the probability of occurrence of a fracture at an interface of the solder joint. Such measurement was conducted for 50 solder bumps. Table 3 shows the measurement results of the interfacial fracture probabilities in the impact test and the pull test.

Table 3

| | Probability of interfacial fracture after micro shot test (%) | | Probability of interfacial fracture after pull test (%) | |
| --- | --- | --- | --- | --- |
| | after soldering | after heating at 150°C for 500h | after soldering | after heating at 150°C for 500h |
| Comparative Specimen 1 | 32 | 100 | 4 | 64 |
| Comparative Specimen 2 | 80 | 96 | 2 | 66 |
| Invention Specimen 1 | 16 | 88 | 2 | 12 |
| Invention Specimen 2 | 25 | 90 | 4 | 40 |
| Invention Specimen 3 | 10 | 75 | 2 | 12 |
| Invention Specimen 4 | 8 | 80 | 2 | 10 |
| Invention Specimen 5 | 15 | 90 | 4 | 30 |
| Invention Specimen 6 | 30 | 90 | 4 | 60 |
| Invention Specimen 7 | 50 | 100 | 8 | 60 |

As can be seen from Table 3, Invention Specimens 1 to 7 exhibit, respectively, a relatively low interfacial fracture probability in both the micro shot test and the pull test. In the pull test, the interfacial fracture probabilities of Invention Specimens 1 to 7 were able to be reduced to around less than 50% even after exposed at a high temperature of 150°C for 500 hours. Especially with regard to Invention Specimens 1 and 3, it was confirmed that a high reliability, such as an interfacial fracture probability of around 10% after the pull test, can be obtained. It is believed that this will be by virtue of restraining of growth of the Cu-Ni-Sn compound by adding proper amounts of Ag and Ni.

On the other hand, Comparative Specimen 2 exhibits a high interfacial fracture probability after the pull test. This means that the joint strength is deteriorated.

According to a result of concentration analysis at a fracture surface in Comparative Specimen 2, it had a concentration corresponding to $(Ni, Cu)_3Sn_4$.

Reviewing Table 3, it is conformed that the specimens having a low Cu/Ni ratio of 20, in particular, the specimens having a low Ni amount exhibit a low interfacial fracture probability after the pull test and thus provide a high reliability.

INDUSTRIAL APPLICABILITY

The invention solder alloy is suitably used for soldering of electrical parts, etc.

**Claims**

1.   A solder alloy consisting of, by mass,

   0.1 to 1.5% Ag;
   0.5 to 0.75% Cu;
   0.01-0.04% Ni wherein $12.5 \leq Cu/Ni \leq 100$; and

   the balance of Sn and unavoidable impurities.

2.   The solder alloy according to claim 1, wherein the solder alloy contains, by mass, 0.3 to 1.2% Ag.

3.   A solder ball formed from the solder alloy as defined in claim 1 or 2 by spheroidizing.

4.   A-solder joint wherein the solder alloy as defined in claim 1 or 2 is bonded to a Ni electrode.

**Patentansprüche**

1.   Lotlegierung, die auf die Masse bezogen aus Folgendem besteht:

   0,1 bis 1,5% Ag;
   0,5 bis 0,75% Cu;
   0,01 bis 0,04% Ni, wobei $12.5 \leq Cu/Ni \leq 100$ gilt; und

   dem Rest aus Sn und unvermeidbaren Verunreinigungen.

2.   Lotlegierung nach Anspruch 1, die auf die Masse bezogen 0,3 bis 1,2% Ag enthält.

3.   Lötperle, die durch Spheroidisierung aus der Lotlegierung nach Anspruch 1 oder 2 gebildet ist.

4.   Lötverbindung, in der die Lotlegierung nach Anspruch 1 oder 2 an eine Ni-Elektrode gebondet ist.

**Revendications**

1.   Alliage de soudure consistant, en masse, en :

   0,1 à 1,5 % d'Ag;
   0,5 à 0,75 % de Cu ;
   0,01 à 0,04 % de Ni où $12,5 \leq Cu/Ni \leq 100$ ; et

   le reste étant du Sn et des impuretés inévitables.

**2.** Alliage de soudure selon la revendication 1, dans lequel l'alliage de soudure contient, en masse, 0,3 à 1,2 % d'Ag.

**3.** Bille de soudure formée à partir de l'alliage de soudure selon la revendication 1 ou 2 par sphéroïdisation.

**4.** Joint à soudure, dans lequel l'alliage de soudure tel que défini dans la revendication 1 ou 2 est lié à une électrode de Ni.

## FIG. 1

INSIDE OF SOLDER

X

Y

ELECTROLYTIC Ni

5 μm

## FIG. 2

INSIDE OF SOLDER

X

Y

ELECTROLYTIC Ni

5 μm

## FIG. 3

INSIDE OF SOLDER

X

Y

ELECTROLYTIC Ni

5 μm

## FIG. 4

INSIDE OF
SOLDER

X
Y

5 μ m

ELECTROLYTIC
Ni

## FIG. 5

INSIDE OF
SOLDER

X
Y

ELECTROLYTIC Ni

5 μ m

# FIG. 6A

ELECTROLYTIC Ni

Y

X

5 μ m

# FIG. 6B

Cu

Sn

Ni
Sn

Ni
Cu

## FIG. 7A

ELECTROLYTIC Ni

Y

X

5 μm

## FIG. 7B

Cu

Sn

Ni

Cu

Sn

Ni

## FIG. 8A

ELECTROLYTIC Ni

Y

X

5 μm

## FIG. 8B

Cu

Sn

Ni
Sn

Cu
Ni

## FIG. 9A

ELECTROLYTIC Ni

Y

X

5 μ m

## FIG. 9B

Cu

Sn

Ni
Sn

Cu
Ni

## FIG. 10A

ELECTROLYTIC Ni

Y

X

5 μm

## FIG. 10B

Cu

Sn

Ni
Sn

Ni
Cu

## FIG. 11

INSIDE OF
SOLDER

X
Y

5 μm

ELECTROLYTIC
Ni

## FIG. 12

INSIDE OF
SOLDER

X
Y

5 μm

ELECTROLYTIC
Ni

# FIG. 13A

ELECTROLYTIC Ni

Y

X

5 μ m

# FIG. 13B

Sn

Cu

Ni

# FIG. 14A

ELECTROLYTIC Ni

Y

X

5 μ m

# FIG. 14B

Sn

Cu

Ni

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11221695 A
- JP 2000190090 A
- JP 2003230980 A